# EUROPÄISCHE PATENTANMELDUNG

(11) **EP 1 622 206 A1**
(43) Veröffentlichungstag der Anmeldung: **01.02.2006**
(21) Anmeldenummer: 04017873.3
(22) Anmeldetag: 28.07.2004
(51) Int. Cl.: H01L 31/115, H01L 31/18

(54) **Halbleiter-Strahlungsdetektoren und Verfahren zur Herstellung derselben**

(71) Anmelder: KEMMER, Josef, Dr., D-85764 Oberschleissheim (DE)
(72) Erfinder: KEMMER, Josef, Dr., D-85764 Oberschleissheim (DE)
(74) Vertreter: Niederkofler, Oswald

(57) **Zusammenfassung**

Die Erfindung betrifft ein Verfahren zur Herstellung von Halbleiter-Strahlungsdetektoren mit einem Grundkörper eines ersten Leitungstyps zum Nachweis der Strahlung und darauf befindlichen strukturierten weiteren Halbleiterschichten eines zweiten und des ersten Leitungstyps, wobei wenigstens eine der weiteren Halbleiterschichten durch Epitaxie aufgebracht wird. Ferner betrifft die Erfindung Verfahren zur Integration von elektronischen Komponenten in Strahlungsdetektoren unter Anwendung der Epitaxie sowie Strahlungsdetektoren vielfältiger Art, bei denen Epischichten als dünne Strahleintrittsfenster, als Guardstrukturen und als Widerstandsschichten aufgebracht sind.

## Beschreibung

Die Erfindung bezieht sich auf ein Verfahren zur Herstellung von Halbleiter-Strahlungsdetektoren sowie auf Halbleiter-Strahlungsdetektoren. Derartige Halbleiter-Strahlungsdetektoren können zum Nachweis und zur Spektroskopie elektromagnetischer Strahlung und von ionisierender Korpuskularstrahlung eingesetzt werden.

Solche Strahlungsdetektoren, vorzugsweise mit Silicium als Grundkörper, sind unter den Bezeichnungen pn-Dioden, Streifendetektoren (SSDs, Silicon Strip Detectors), Silicium-Driftdetektoren (SDDs, Silicon Drift Detectors), CCDs (Charge Coupled Devices), Pixel-Detektoren usw. im Handel erhältlich. Sie sind in einer Reihe von Publikationen und Patenten bzw. Patentanmeldungen beschrieben worden (DE0003507763A1, DE 0003415439A1, US 4,688,067 A, US 5,773,829 A, US 6,455,858 B1, US 4,837,607 A, US 4,885,620 A, US 5,424,565 A).

Bei den in diesen Anmeldungen beschriebenen Ausführungsbeispielen sind auf einem Halbleiterkörper des ersten Leitungstyps - vorzugsweise aus n-Typ Silicium - auf den Hauptoberflächen Schichten eines zweiten und ersten Leitungstyps durch Dotierung erzeugt. In der Regel werden die Dotierungen durch Ionenimplantation oder in manchen Fällen auch durch Diffusion vorgenommen.

Bei einer pn-Diode (oft auch alsPIN-Diode bezeichnet), dem einfachsten Typ von Strahlungsdetektor wird z.B. ein Halbleiterkörper aus Silicium mit einer sehr niedrigen n-Typ Dotierung im Bereich der einen Hauptoberfläche durch Ionenimplantation in einen p-Typ Halbleiter umdotiert und im Bereich der anderen Hauptoberfläche ebenfalls durch Implantation die n-Typ Dotierung erhöht.

Beim Betrieb der pn- Diode wird durch Polung des pn-Überganges in Sperrichtung eine ladungsträgerfreie Zone aufgebaut, die sogenannte Raumladungszone, die zum Nachweis der Strahlung dient. Wird in dieser Schicht elektromagnetische oder ionisierende Strahlung absorbiert, so werden dort in bekannter Weise Elektron/Loch-Paare generiert, deren Menge der Intensität bzw. der Energie der absorbierten Strahlung proportional ist. Diese werden durch das elektrische Feld getrennt und wandern zu den Hauptoberflächen, wo sie mit Hilfe geeigneter elektrischer Verstärkung zur Registrierung und Analyse der Strahlung herangezogen werden können. Prinzipiell funktionieren auch die anderen, oben beispielhaft aufgezählten Strahlungsdetektoren nach diesem Prinzip.

Ein wichtiges Kennzeichen eines Strahlungsdetektors ist die Dicke des Strahleintrittsfensters, oder der sogen. Totschicht. Um Absorptionen so gering wie möglich zu halten, soll diese Schicht möglichst dünn sein. Um dieses Ziel zu erreichen, werden die pn-Übergänge bei Strahlungsdetektoren in der Regel stark asymmetrisch und abrupt ausgeführt. Dies erreicht man entweder durch Metall/Halbleiter-Übergänge (Schottky-Barrieren), durch Oberflächen-Sperrschichten (Surface Barrier) oder durch Dotierung mit Hilfe der Diffusion oder der Ionenimplantation. Dabei ist die Ionenimplantation mittlerweile das bevorzugte Dotierungsverfahren, da sich durch Variation der Dosis und der Energie des Dotiermaterials die Dotierungsprofile in weiten Grenzen variieren lassen. In der Regel weisen die Dotierprofile jedoch keinen abrupten Verlauf auf, sondern zeigen eine annähernd gaußförmige Verteilung der Dotierstoffe in die Tiefe des Halbleiterkörpers.

Ein weiterer Nachteil der Implantationsdotierung ist die Entstehung von Kristallschäden, die durch eine anschließende Temperung beseitigt werden müssen. Dabei kommt es jedoch zu einer zusätzlichen unerwünschten Verschmierung der Profile. Diese Schichten weisen deshalb den Nachteil auf, daß sie nicht beliebig dünn gemacht werden können und daß ihre effektive Dicke von der angelegten Betriebsspannung des Detektors sowie den Ausheizparametern abhängt. Ja, sie kann sich im Laufe der Zeit durch Bestrahlung weiter verändern.

Durch Implantation hergestellte Strahleintrittsfenster weisen aufgrund ungenügender Dotierstoffkonzentration einen hohen Schichtwiderstand auf, der es erforderlich macht, sie noch mit einer Metallelektrode, wie z.B. Aluminium zu versehen.

Zusätzlich sind die noch verbleibenden Kristallschäden und metallischen Verunreinigungen, die mitimplantiert werden können, eine Quelle unerwünschter Leckströme, die Signale verfälschen. Alle diese Effekte machen sich besonders nachteilig beim Vermessen von Strahlung bemerkbar, die im Silicium nur eine sehr geringe Reichweite hat, wie z.B. UV-Licht oder niederenergetische Röntgenstrahlung im Energiebereich unter 500 eV.

Erfindungsgemäß ist nun erkannt worden, daß durch Anwendung der Epitaxie anstelle der Ionenimplantation für die Herstellung der Schichten des zweiten und ersten Leitungstyps auf dem Halbleiterkörper, diese Nachteile alle vermieden werden können.

Mit Hilfe des in Anspruch 1 gekennzeichneten Verfahrens ist es möglich, die Schichtdicken und die Dotierstoffkonzentrationen in weiten Grenzen zu variieren. Es ist technisch kein Problem mit Hilfe geeigneter Epitaxieverfahren abrupte Dotierprofile, ja sogar sogen. Deltaschichten zu erzeugen. Da Dotierstoffkonzentrationen bis zu 10E21 pro ccm möglich sind, ist die Herstellung extrem dünner abrupter Schichten des zweiten oder ersten Leitungstyps im Dickenbereich von einigen nm auf einem Halbleiterkörper des ersten Leitungstyps ohne weiteres realisierbar.

Diese Epischichten besitzen noch genügend hohe Leitfähigkeit, so daß auf eine Metallelektrode verzichtet werden kann. Sie eignen sich deshalb erfindungsgemäß in besonders vorteilhafter Weise als Eintrittsfenster für Strahlung kurzer Reichweite. Sie übertreffen darüberhinaus die durch Implantation hergestellten dünnen Schichten nicht nur durch ihre geringer Dicke, sondern durch ein beliebig einstellbares Dotierungsprofil, das in der Regel homogen gestaltet wird. Damit sind diese Epischichten auch strahlenhärter und langzeitstabil.

Die gezielte Dotierung der Epischicht im Eintrittsfenster ist für Röntgendetektoren besonders vorteilhaft, denn das niederenergetische Röntgenstpektrum wird durch die Dicke und die Dotierung des Eintrittsfensters stark beeinflußt. Wenn niederenergetische Röntgentrahlung das Eintrittsfenster passiert, wird sie bekanntermaßen teilweise absorbiert, so daß die im Detektor gemessene Zahl der Röntgenquanten geringer ist als ihre primäre Anzahl. Jedoch können Elektronen, die bei der Absorption eines Röntgenquantes in der Totschicht generiert werden in den Detektor gelangen und das Spektrum verfälschen.

Einen noch stärkeren Einfluß auf die Form des Spektrums haben Elektronen, die bei der Absorption der Strahlung knapp unterhalb des Fensters im Detektor gebildet werden, den Detektor aber aufgrund ihrer Energie (einige eV) durch das Fenster verlassen. Durch den Einbau einer Potentialbarriere in das Eintrittsfenster können diese Elektronen wieder in den Detektor zurückreflektiert werden.

Eine solche Potentialbarriere läßt sich durch gezielte Dotierung der Epischicht im Eintrittsfenster realisieren.Dazu wird auf einem n-Typ Grundkörper zunächst eine n-Typ Epischicht mit erhöhter n-Dotierung und darauf eine sehr dünne Epischicht mit sehr hoher p-Dotierung abgeschieden.Die Dicke und die Dotierung der n-dotierten Epischicht werden so gewählt(z.B. hundert mal höher als die Grunddotierung), daß über diesen pn-Übergang in der Epischicht einige Volt Spannung abfallen. Dieses Potential müssen nun die Elektronen aus dem Detektor überwinden, um zu entkommen.

Eine weitere Möglichkeit, eine Potentialbarriere aufzubauen besteht darin, auf die Epischicht des Eintrittsfensters eine dünne Schicht eines Dielektrikums, vorzugswiese ein thermisches Oxid, aufzubringen. In diesem Fall kann die Dotierung der Epischicht homogen sein, da die Höhe der Potentialbarriere durch die Austrittsarbeit der Elektronen bzw. Löcher aus dem Silicium in das Dielektrikum (ca. 3,2 eV beim Siliciumoxid) bestimmt wird.

Da die Epitaxieschichten fast defektfrei auf den Grundkörper aufgewachsen werden können, weisen sie im Gegensatz zu implantierten Schichten weniger Störstellen auf, die als Generations- bzw. Rekombinationszentren für Ladungsträger wirken können. Detektoren, die nach dem erfindugsgemäßen Verfahren hergestellt sind, zeichnen sich deshalb durch geringere Leckströme und bessere spektroskopische Eigenschaften aus.

Ein weiterer Vorteil des in Anspruch 1 gekennzeichneten Verfahrens besteht darin, daß diese Epitaxieschicht des zweiten Leitungstyps gleichzeitig dazu benutzt werden kann, die elektrischen Felder im Randbereich des Detektors trischen Felder im Randbereich des Detektors abzubauen. Dies läßt sich in bekannter Weise entweder durch sogen. Guardringe realisieren, oder noch einfacher durch eine Widerstandsschicht auf dem passivierenden Oxid. In den bekannten Ausführungen von Strahlungsdetektoren werden die Guardringe ebenfalls mit Ionenimplantation hergestellt. Für die Herstellung der Widerstandsschichten auf dem Oxid, kommen entweder amorphes Silicium oder Polysilicium zur Anwendung. Dazu ist jedoch ein zusätzlicher Prozeßschritt erforderlich. Das erfindungsgemäße Verfahren zeichnet sich demnach auch dadurch aus, daß weniger Technologieschritte benötigt werden.

Besonders vorteilhaft bei dem erfindungsgemäßen Verfahren ist die Anwendung der selektiven Epitaxie, da dann die Strukturierung der Epischicht entfällt, denn das Episilicum scheidet sich dabei nur auf den freigeätzten Siliciumbereichen ab.

Weiterbildungen des erfindungsgemäßen Verfahrens sind in den Unteransprüchen angegeben. Von besonderem Interesse ist dabei die Anwendung bei der Herstellung komplexer Bauelemente wie SDDs und CCDs und Pixdldetektoren, sowie bei Bauelementen mit integrierten elektronischen Komponenten.

Das erfindungsgemäße Verfahren wird nachstehend ohne Beschränkung des allgemeinen Erfindungsgedankens anhand von Ausführungsbeispielen - in denen hochreines n-Typ Silicium, vorzugsweise mit der Orientierung (100) als Grundkörper gewählt wurde - unter Bezugnahme auf die Zeichnungen exemplarisch beschrieben, auf die im übrigen hinsichtlich der Offenbarung aller im Text nicht näher erläuterten erfindungsgemäßen Einzelheiten ausdrücklich verwiesen wird. Es zeigen:
Fig. 1a einen Querschnitt durch einen mit Hilfe der Ionenimplantation hergestellten einfachen Strahlungsdetektor mit Guardringen
Fig. 1b einen Querschnitt durch ein mit Fig. 1a vergleichbares erstes Ausführungsbeispiel des erfindungsgemäßen Verfahrens (pn-Guardringe) mit Schichten des zweiten Leitungstyps auf der ersten Hauptoberfläche und Schichten des ersten Leitungstyps auf der zweiten Hauptoberfläche
Fig. 2a einen Querschnitt durch den Randbereich eines mit Hilfe der Ionenimplantation hergestellten einfachen Strahlungsdetektors mit einer Widerstandsschicht aus amorphem Silicium im Randbereich zum Abbau des elektrischen Feldes
Fig. 2b einen Querschnitt durch ein mit Fig. 2a vergleichbares zweites Ausführungsbeispiel des erfindungsgemäßen Verfahrens mit einer Epitaxieschicht des zweiten Leitungstyps zum Abbau des elektrischen Feldes im Randbereich
Fig. 3a einen Querschnitt durch den Randbereich eines dritten Ausführungsbeispiels des erfindungsgemäßen Verfahrens, einen Strahlungsdetektor mit Widerstandsstrukturen des zweiten Leitungstyps zum Abbau des elektrischen Feldes
Fig. 3b die Aufsicht auf ein viertes Ausführungsbeispiel des erfindungsgemäßen Verfahrens, einen Strahlungsdetektor rechteckiger Geometrie mit schematischer Darstellung einer Widerstandsspirale des zweiten Leitungstyps zum Abbau des elektrischen Feldes im Randbereich
Fig. 3c die Aufsicht auf eine fünftes Ausführungsbeispiel, einen Strahlungsdetektor runder Geometrie mit schematischer Darstellung mit einander verbundener Ringe des zweiten Leitungstyps zum Abbau des elektrischen Feldes im Randbereich
Fig. 4a den Querschnitt durch ein sechstes Ausführungsbeispiel des erfindungsgemäßen Verfahrens, einen Silicium Driftdetektor mit einer zentralen Elektrode A (Anode) des ersten Leitungstyps auf der ersten Hauptoberfläche, umgeben von konzentrischen Ringen R1, R2, --- Rn bzw. einer Widerstandsspirale des zweiten Leitungstyps zur Erzeugung des Driftfeldes und mit Guardringstrukturen w11, w12, --- w1n des zweiten Leitungstyps im Randbereich zum Abbau des elektrischen Feldes
Fig. 4b den Querschnitt durch ein siebtes Ausführungsbeispiel des erfindungsgemäßen Verfahrens, einen Silicium Driftdetektor wie in Fig. 4a,jedoch mit einer zusätzlichen Epitaxieschicht E1 des ersten Leitungstyps im Bereich der ersten Hauptoberfläche
Fig. 5a einen Querschnitt durch ein achtes Ausführungsbeispiel des erfindungsgemäßen Verfahrens, einen Silicium Driftdetektor mit einer zentralen Elektrode A (Anode) des ersten Leitungstyps auf der ersten Hauptoberfläche, umgeben von einer Widerstandsschicht ws1 des zweiten Leitungstyps zur Erzeugung des Driftfeldes und mit Guardringstrukturen w11, w12, --w1n des zweiten Leitungstyps im Randbereich zum Abbau des elektrischen Feldes, sowie mit einer Schicht po1 des zweiten Leitungstyps auf der zweiten Hauptoberfläche .
Fig. 5b einen Querschnitt durch ein neuntes Ausführungsbeispiel des erfindungsgemäßen Verfahrens, einen Silicium Driftdetektor wie in Fig. 5a, jedoch mit punktförmiger Me21 zentraler und ringförmiger äußerer Me22 Kontaktierung der Schicht des zweiten Leitungstyps auf der zweiten Hauptoberfläche zur Erzeugung eines Spannungsgradienten.
Fig. 6 einen Querschnitt durch ein zehntes Ausführungsbeispiel des erfindungsgemäßen Verfahrens, einen Silicium Driftdetektor mit einer Widerstandsschicht ws1 des zweiten Leitungstyps auf der ersten Hauptoberfläche, umgeben von einem Ring A des ersten Leitungstyps, einem zentralen Kontakt Me11 zur Widerstandsschicht und einem äußeren ringförmigen Kontakt Me12 der Widerstandsschicht, sowie einer Epischicht p02 (E2) des zweiten Leitungstyps auf der zweiten Hauptoberfläche
Fig. 7a einen Querschnitt durch ein elftes Ausführungsbeispiel des erfindungsgemäßen Verfahrens mit einer Epischicht E1 des ersten und zweiten E2 Leitungstyps auf der ersten Hauptoberfläche eines Halbleitergrundkörpers und mit Bereichen B1, B2, --Bn zusätzlicher Dotierung des zweiten (oder ersten) Leitungstyps in der Epichicht E2 des zweiten Leitungstyps
Fig. 7b einen Querschnitt durch ein zwölftes Ausführungsbeispiel des erfindungsgemäßen Verfahrens mit einer Epischicht des ersten E1 und zweiten E2 Leitungstyps auf der ersten Hauptoberfläche eines Halbleitergrundkörpers und lokal aufgebrachten zusätzlichen Schichten des zweiten Leitungstyps B1, B2---Bn
Fig. 7c einen Querschnitt durch ein dreizehntes Ausführungsbeispiel des erfindungsgemäßen Verfahrens mit einer Epischicht des ersten E1 und zweiten E2 Leitungstyps auf der ersten Hauptoberfläche eines Halbleitergrundkörpers und lokal aufgebrachten zusätzlichen Schichten des ersten Leitungstyps B1, B2, --- Bn.

In den folgenden Figuren sind gleiche Elemente immer mit den selben Bezugszeichen versehen, so daß bei der Vorstellung der einzelnen Figuren auf die notwendige Beschreibung bereits beschriebener Elemente verzichtet wird.

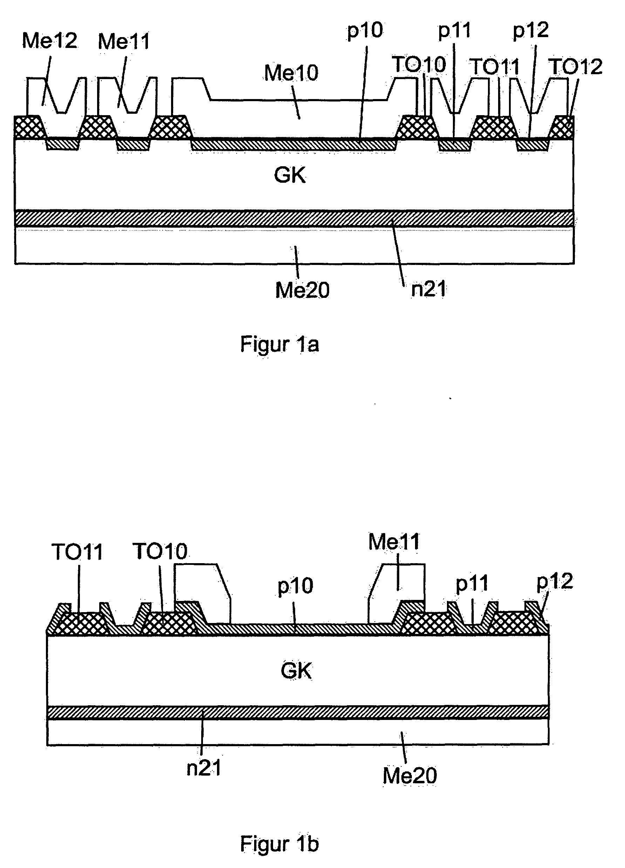

Fig. 1a zeigt einen Querschnitt durch ein einfachen pn-Detektor oder pin-Diode. Der Detektor ist nach dem bekannten Verfahren der Ionenimplantation hergestellt. Er besitzt einen Grundkörper GK des ersten Leitungstyps mit n-Typ Dotierung. Auf der ersten Hauptoberfläche befinden sich Gebiete des zweiten Leitungstyps p10, p11, p12, -- p1n, die durch Ionenimplantation hergestellt sind. Sie sind voneinander durch isolierendes thermisches Oxid TO getrennt. Über den Schichten sind Metallelektroden Me aus Aluminium angebracht.

Auf der zweiten Hauptoberfläche befindet sich eine dünne hochdotierte Schicht des ersten Leitungstyps n21, die durch Implantation hergestellt worden ist. Darüber befindet sich wieder eine Metallelektrode Me20 aus Aluminium.

Das zentrale Gebiet des zweiten Leitungstyps p10 auf der ersten Hauptoberfläche dient gleichzeitig als Eintrittsfenster der Strahlung und zur Erzeugung der Ladungsträger freien Raumladungszone bei Polung in Sperrichtung. Umgeben ist dieser Zentralteil von ringförmigen Zonen des zweiten Leitungstyps p11, p12, ---p1n., die als Guardringe dienen und das elektrische Feld nach außen abbauen.

Fig. 1b zeigt einen Querschnitt durch ein vergleichbaren pn-Detektor, der jedoch nach dem erfindungsgemäßen Verfahren hergestellt worden ist. Die Schichten des zweiten Leitungstyps p10 bis p1n auf der ersten Hauptoberfläche und die des ersten Leitungstyps n21 auf der zweiten Hauptoberfläche sind durch Epitaxie, vorzugsweise selektive Epitaxie abgeschieden.

Im Gegensatz zu Fig. 1 ist nur eine Metallelektrode Me11 auf der ersten Hauptoberfläche in Form eines Ringes als Bondpad vorhanden, der benötigt wird, um die elektrischen Verbindungen zur Elektronik herzustellen. Dieser besteht vorzugsweise aus TiN und Aluminium darüber. Dabei dient das TiN dazu, das Legieren von Al mit dem Silicium der Epischicht zu vermeiden.

Genau wie bei der Ionenimplantation können bei Anwendung der Epitaxie das Strahleintrittsfenster p10 und die Guardringe p11 bis p1n gleichzeitig hergestellt werden.

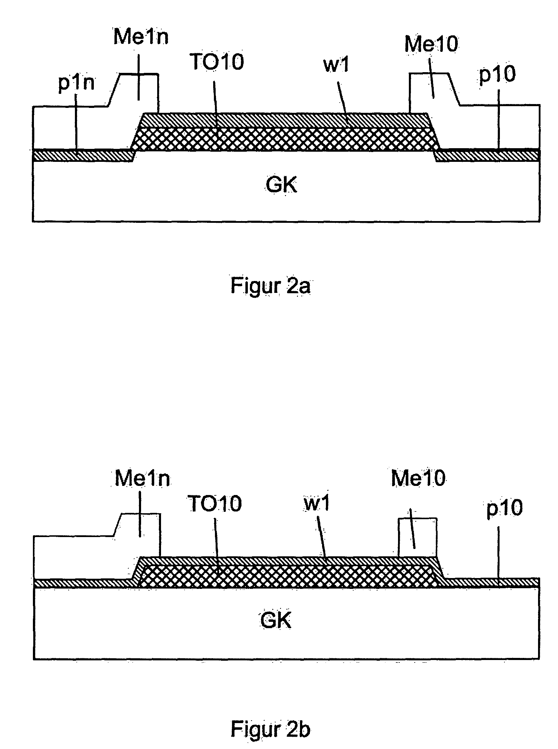

Fig. 2a zeigt den Schnitt durch den Randbereich eines einfachen durch Ionenimplantation hergestellten pn-Detektors, bei dem jedoch der Spannungsabbau mit Hilfe einer Widerstandsschicht w1 wie z.B. Polysilicium oder amorphes Silicim erzielt wird. Die Widerstandsschicht w1 kann ganzflächig aufgebracht sein, oder in Form einer Spirale bzw. in Form miteinander verbundener Ringe w11 bis w1n strukturiert sein. Bei einer ganzflächigen Widerstandsschicht kann der gewünschte Verlauf des Widerstandes zum Rand hin auch durch Freiätzen mehr oder weniger großer Flächen eingestellt werden. Die Widerstandsschicht ist auf der einen Seite mit dem Eintrittsfenster p10 und am anderen Ende p1n mit dem Grundkörper GK elektrisch verbunden.

Idealerweise sollte die äußere Kontaktierung der Widerstandsschicht w1 mit dem Grundkörper GK über einen Kontakt des gleichen Leitungstyps wie der des Grundkörpers erfolgen. Dies läßt sich jedoch vermeiden, wenn dieser Kontakt gleichzeitig als Separationslinie des Halbleiterchips benutzt wird, da in diesem Fall aufgrund des Schnittes die sperrende Wirkung eines Kontaktes vom zweiten Leitungstyp zerstört wird und sich der Kontakt ohmisch verhält.

Fig. 2b zeigt den Querschnitt durch einen ähnlich aufgebauten pn-Detektor, bei dem jedoch die Widerstandsschicht w1 aus derselben Epischicht besteht wie das Eintrittsfenster p10, das gleichzeitig mit dieser abgeschieden wird.

Das erfindungsgemäße Verfahren benötigt damit keine zusätzliche Abscheidung der Widerstandsschicht und erfordert damit mindestens eine Maskenebene weniger zur Strukturierung.

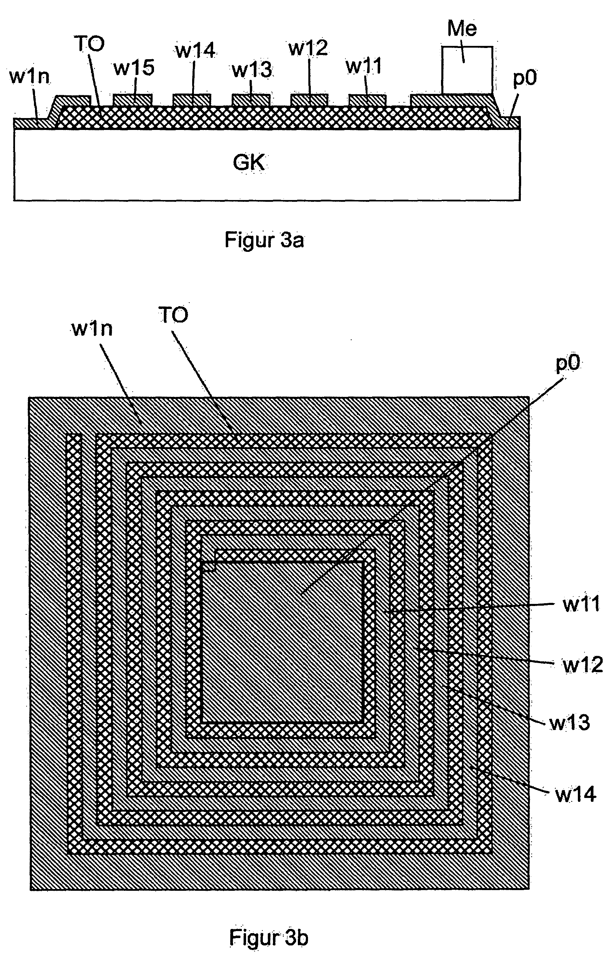

Fig. 3a zeigt den Querschnitt durch einen Detektor, dessen Widerstandsschicht im Randbereich nach dem erfindungsgemäßen Verfahren als Spirale w11, w12, -- w1n bzw. zusammenhängende Ringstruktur w11, w12, --- w1n ausgeführt ist.

Fig. 3b ist eine schematische Darstellung der Aufsicht auf einen rechteckigen Detektor mit einer Spiralstruktur w11, w12, --- w1n der Widerstandsschicht des Randbereichs.

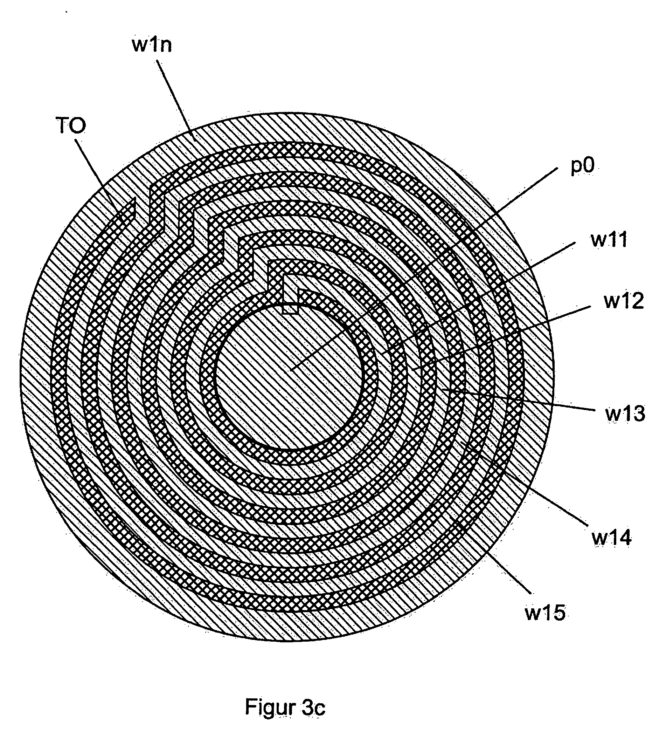

Fig. 3c. zeigt eine runde Struktur mit zusammenhängenden Ringen w11, w12, --- w1n als Widerstandsschicht. Der äußere Kontakt w1n liegt wieder auf der Separationslinie.

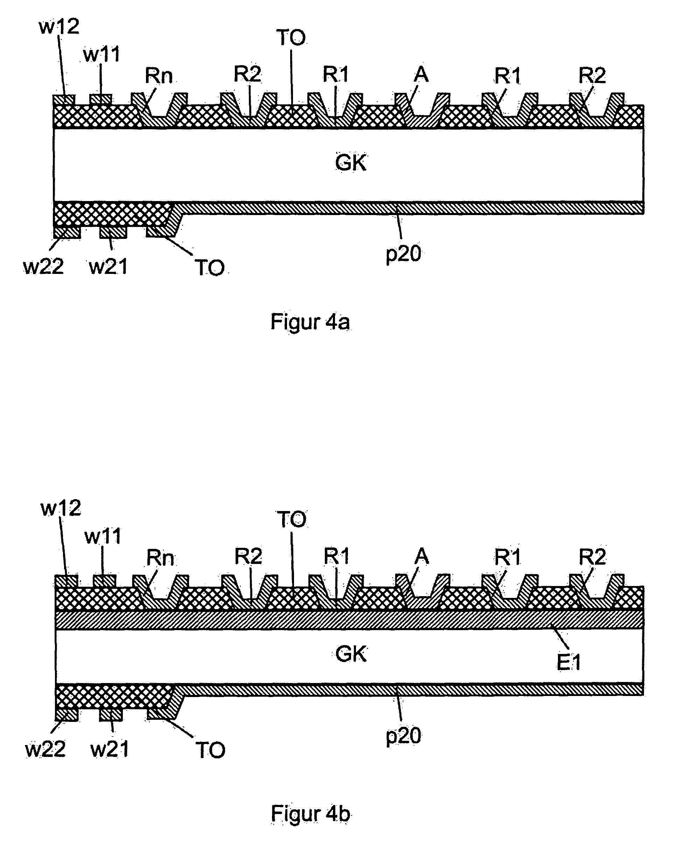

Fig. 4a zeigt als drittes Ausführungsbeispiel einen an sich bekannten Silicium Drift Detektor (SDD), bei dem alle Gebiete des zweiten und ersten Leitungstyps im Bereich der beiden Hauptoberflächen durch Epitaxie, vorzugsweise selektiver Epitaxie hergestellt sind. Die bei SDDs erforderliche Driftspannung kann in bekannter Weise durch Driftringe R1, R2, --- Rn oder durch eine Spirale R1, R2, --- Rn erzeugt werden bzw. vorteilhafterweise und erfindungsgemäß durch Ringe, die unterbrochen und miteinander verbunden sind, ähnlich der Ausführung in Fig. 3c. Zur Ableitung der Elektronen unter dem Oxid TO eignet sich ebenfalls eine verbundene Ringstruktur (nicht gezeigt) von Episilicium auf dem Oxid. Diese kann in einem Schritt gleichzeitig mit den Driftringen R1, R2,-Rn hergestellt werden. Wie im Ausführungsbeispiel drei beschrieben kann die Epischicht auch zum Spannungsabbau im Randbereich benutzt werden (w11, w12, --- w1n).

Im Zentrum der ersten Hauptoberfläche befindet sich eine Anode A vom Leitungstyp des Grundkörpers. Sie stellt den Kontakt zum Grundkörper her und dient zum Absaugen der durch Strahlung erzeugten Majoritätsladungsträger. Die Anode kann ebenfalls aus Episilicium hergestellt werden und wird mit einem Metallkontakt, vorzugsweise TiN und Aluminium versehen.

Zum Ableiten der Elektronen von der Anode dient eine in der Zeichnung nicht gezeigte integrierte Diode oder eine hochohmige Verbindung zum Grundkörper, die vorzugsweise aus Episilicium besteht oder durch Ionenimplantation hergestellt wird. Besonders vorteilhaft ist es, die Anode über diesen Widerstand mit der selben Elektrode zu verbinden, die zum Absaugen der Elektronen unter dem Oxid dient.

Auf der Strahleintrittseite besteht dieses Ausführungsbeispiel einer SDD mit Epitaxieschichten aus einer einfachen pn-Diode p20 mit Strukturen w21, w22, --- w2n zum Spannungsabbau, wie sie bereits beschrieben wurden.

Die wesentlichen Vorteile von SDDs, die nach dem erfindungsgemäßen Verfahren hergestellt sind, bestehen darin, daß die Strahleintrittsfenster p20 extrem dünn, z.B. 5 bis 30 nm, gemacht werden können, daß diese sehr homogen sind, daß sie in weiten Grenzen dotiert werden können und strahlenhart sind. Aufgrund der sauberen und weitgehend defektfreien Grenzfläche zwischen den Epischichten und dem Grundkörper ist der Leckstrombeitrag aus diesem Bereich vernachlässigbar.

Da die Epischicht mit definiertem Schichtwiderstand hergestellt werden kann, ist es möglich, anstelle der Spannungsteilung durch konzentrische Driftringe, eine Spiralstruktur oder einfach offene Ringe zu benutzen, die an den beiden Enden mit den beiden Nachbarringen verbunden sind, ähnlich der in Fig. 3c dargestellten Form. Der damit erzielte Spannungsteiler ist unempfindlich gegen Bestrahlung und daher langzeitstabil.

Ein weiterer Vorteil des erfindungsgemäßen Verfahrens besteht darin, daß auch hier, wie bei den einfachen pn-Dioden, die hohen Feldstärken am Rande des Detektors über geeignet ausgeführte Widerstandsstrukturen aus Episilicium abgebaut werden können, die in einem einzigen Abscheideprozeß zusammen mit dem Eintrittsfenster bzw. den Driftstrukturen hergestellt werden. Vorteilhafterweise werden hier gleichfalls offene Ringstrukturen mit Verbindungen zu den Nachbarringen benutzt. Diese können als pn-Strukturen ausgeführt werden, oder einfach auf die passivierende Oxidschicht abgeschieden werden.

Fig. 4b zeigt ein Ausführungsbeispiel eines Driftdetektors mit ähnlichem Aufbau wie in Fig. 4a, jedoch weist dieses Bauelement auf der ersten Hauptoberfläche eine zusätzliche Epischicht E1 von mehrerenn Mkrometern Dicke mit erhöhter Dotierung des selben Leitungstyps wie der Grundkörper auf. Ein Vorteil dieser Ausführungsform besteht darin, daß die auf der Strahleintrittseite angelegte Sperrspannung zur Verarmung des Grundkörpers eine höhere Toleranz aufweist. Durch die erhöhte Dotierung unter den Driftringen, wird ein durch ungleichmäßige Dotierung des Grundkörpers bedingter lokaler "Punchthrough" reduziert. Ein SDD dieser Ausführungsform ist unempfindlicher gegen Spannungsveränderungen und verhält sich im praktischen Einsatz stabiler.

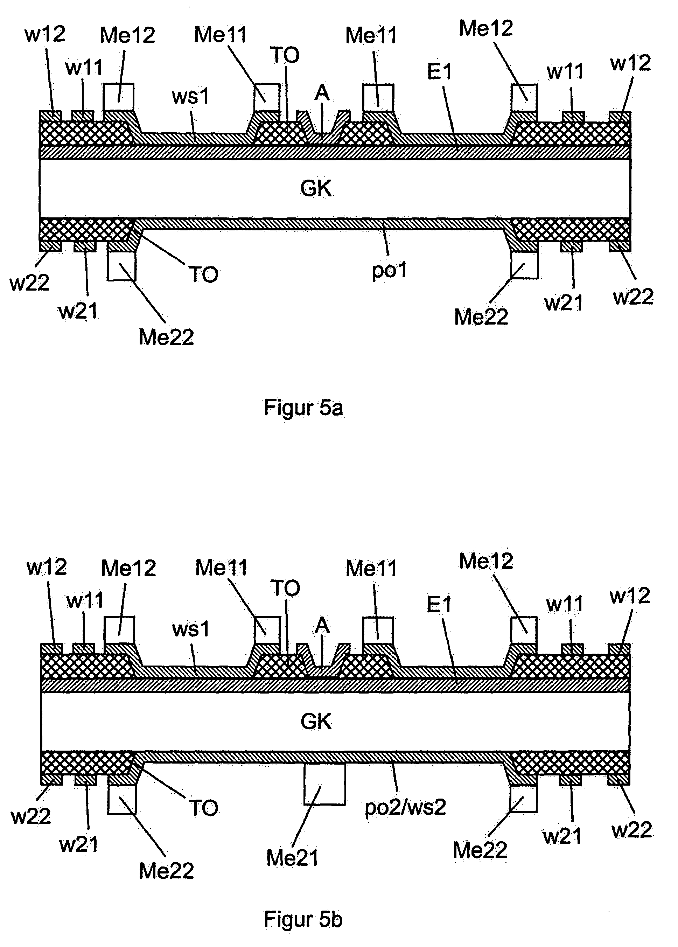

Fig. 5a zeigt ein Ausführungsbeispiel eines Driftdetektors mit einer zentralen Anode A des ersten Leitungstyps auf der ersten Hauptoberfläche, umgeben von einer epitaktischen Widerstandsschicht ws1 des zweiten Leitungstyps mit einem inneren Me11 und äußeren Me12 Kontaktring zur Erzeugung des Driftfeldes.

Ein besonderer Vorteil dieser Anordnung besteht darin, daß auf der ersten Hauptoberfläche im Bereich des Driftfeldes keine Oxidschichten mehr vorhanden sind. Bekanntermaßen werden unter dem Oxid Ladungsträger generiert, die einen Rauschbeitrag leisten können, wenn sie nicht vollständig abgeführt werden. Ein weiterer Nachteil von Oxiden ist ihre Strahlenschädigung und die damit verbundene Erhöhung der Grenzflächenzustandsdichte. Beide Effekte können zur Verschlechterung der Eigenschaften von SDDs während ihres Betriebes beitragen, insbesondere wenn zur Erzeugung des Driftfeldes konzentrische Ringe benutzt werden, die zum Spannungsabbau den Punchthrough Effekt benutzen.

Fig. 5b zeigt den identischen Aufbau eines weiteren Ausführungsbeispiels, bei dem jedoch die Epischicht po2 bzw. ws2 des zweiten Leitungstyps auf der zweiten Hauptoberfläche mit einer zentralen Elektrode Me21 und einem Kontaktring Me 22 im Außenbereich kontaktiert ist und ebenfalls als Spannungsteiler genutzt wird.

Flächenartige geschlossene Widerstandsschichten aus Episilicium lassen sich immer dann vorteilhafterweise zur Erzeugung des Driftfeldes anwenden, wenn die Driftregionen linear sind. Bei zirkularer Anordnung der Driftgebiete verändert sich der Widerstand mit dem Radius und das elektrische Feld im Randbereich wird sehr schwach. Die Ladung bewegt sich demzufolge im Randbereich langsamer als im Zentrum. Da die Fläche des Detektors mit dem Radius quadratisch anwächst, trifft der überwiegende Teil der Strahlung den Randbereich und hat damit einen größeren Weg zurückzulegen. Dies läßt sich durch Vertauschen der Potentialverhältnisse verbessern, wie im folgenden Beispiel gezeigt wird.

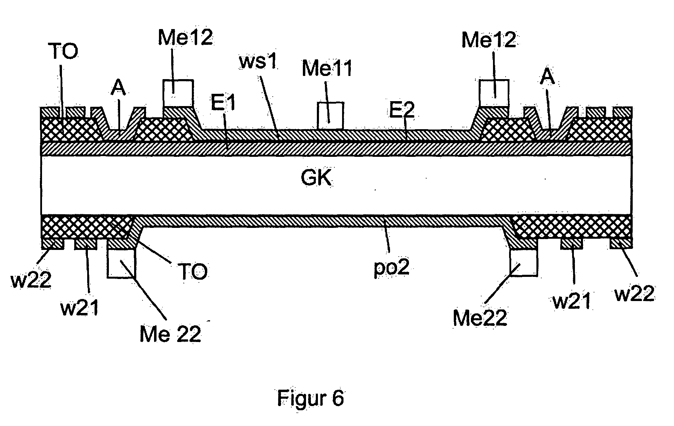

Fig. 6 zeigt den Querschnitt durch ein Ausführungsbeispiel eines SDD, bei dem auf der ersten Hauptoberfläche eine Epischicht E2 (ws1) des zweiten Leitungstyps abgeschieden ist, die einen punktförmigen zentralen Me11 und einen ringförmigen peripheren Me12 Kontakt aufweist. Im äußeren Randbereich befindet sich eine ringförmige Anode A des ersten Leitungstyps. Dieses Bauelement wird so betrieben, daß das Driftfeld nach außen gerichtet ist und die Majoritätsladungsträger auf der ringförmigen Anode A gesammelt werden.

Diese Ausführungsform eines SDD weist den Vorteil der besseren Ladungssammlung auf, besitzt aber den Nachteil einer höheren Anodenkapazität und damit verbunden ein höheres elektronisches Rauschen. Es hat aber auch neben dem bereits beschriebenen noch einige weitere Vorteile. Die Elektrode mit der höchsten Spannung befindet sich im Zentrum und nicht am Rand des Bauelementes, es sind also keine Guardstrukturen zum Spannungsabbau im Außenbereich erforderlich. Besonders vorteilhaft ist diese Betriebsart bei Arrays, da im Grenzbereich der einzelnen Zellen keine hohen Felder abzubauen sind. Die außenliegende Anode kann sogar für einige oder alle Zellen gemeinsam genutzt werden. Damit läßt sich der unerwünschte Ladungsverlust im Randbereich von SDDs vermeiden. Derartige SDDs können dort sinnvoll zur Anwendung kommen, wo die Anforderungen an die spektroskopischen Eigenschaften nicht sehr hoch sind, aber der mechanische Aufbau einfach und robust sein muß, wie z.B. in der Kombination mit Szintillatoren für die Medizintechnik.

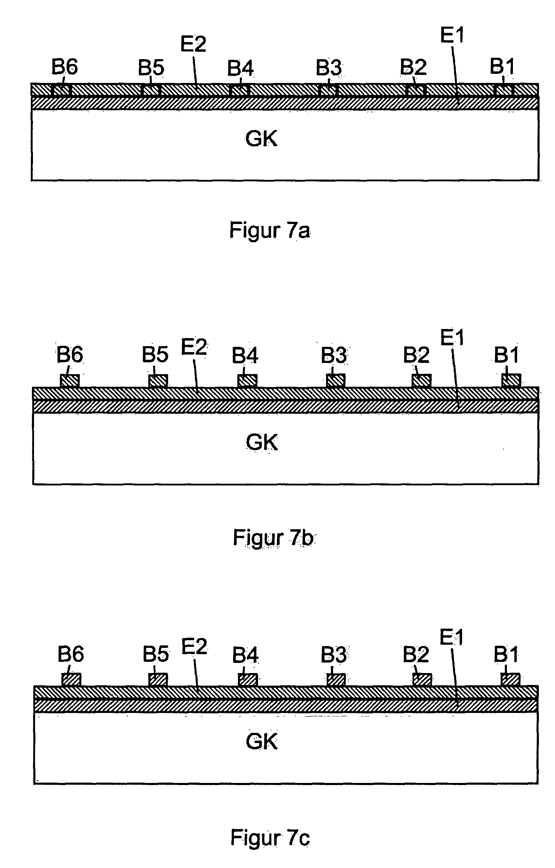

Fig. 7a bis Fig. 7c bringen Beispiele dafür, wie die Leitfähigkeit der Epischicht E2 des zweiten Leitungstyps lokal verändert werden kann, um z.B. die oben beschriebenen Nachteile zu verbessern. Dazu ist nach Fig. 7a eine lokale Dotierung B1, B2, --- Bn durch Ionenimplantation vorgesehen, nach Fig. 7b, eine weitere Epischicht höherer Dotierung und nach Fig. 7c, eine Epischicht vom entgegengesetzten Leitungstyp. Durch geeignete Strukturierung der Epischichten nach Fig. 7b und Fig. 7c, wird in den Bereichen B1, B2, --- Bn, wo die zusätzliche Epischicht stehen bleibt, der Schichtwiderstand verändert. Zur Strukturierung können bekannte trocken- oder naßchemische bzw. elektrochemische Ätzverfahren angewandt werden. Besonders einfach ist die Strukturierung von n-Typ Epi auf einer hochdotierten p-Typ Siliciumschicht, da zum Ätzen KOH benutz werden kann, die n-Typ Silicium mit höherer Rate als p-Typ Silicium ätzt. Eine hochdotierte Schicht aus p-Typ Silicium stellt damit einen Atzstopp dar.

Besonders vorteilhaft für die Strukturierung der Epitaxiegebiete ist die Anwendung der selektiven Epitaxie. Bei diesem Verfahren, das sich sehr gut für dünne Epischichten eignet, scheidet sich das epitaktische Silicium nur auf freigelegtem Silicium und nicht auf dem Oxid ab. Damit läßt sich die Maske zum Strukturieren der Epischicht einsparen.

Der Einsatz der epitaktischen Schichtabscheidung für die Herstellung von Strahlungsdetektoren eignet sich auch in hervorragender Weise dafür, um auf die Detektoren unterschiedliche elektronische Bauelemente zu integrieren. Dazu zählen beispielsweise Widerstände, Kapazitäten, Leiterbahnen, Dioden, MOSFETs, JFETs und Bipolartransistoren.

Die bekannten SDDs mit integriertem ersten JFET nutzen ausschließlich die Ionenimplantation zur Erzeugung der für einen JFET erforderlichen Dotierungsschichten. Sie weisen deshalb bekanntermaßen eine Reihe von Nachteilen sowohl im Fertigungsprozeß als auch in ihren Eigenschaften auf, von denen die wichtigsten aufgelistet seien:
Hohe Implantationsenergien mit breiter Verschmierung der Dotierungsprofile,
Unsicherheiten in den Dotierungen, die zu starker Streuung der Transistorparameter führen, restliche Strahlenschäden und Verunreinigungen während der Implantation, die Ursache für erhöhtes Rauschen der Transistoren darstellen,
schlechte Steilheit der Transistoren,
mehrere Implantationsschritte mit der dazu erforderlichen Fototechnik,
Einbau des Transistors in den Detektor statt auf den Detektor, was zu reduzierter Empfindlichkeit im Transistorbereich führt.
Ausfallrisiko und hohe Fertigungskosten.

Bei der Herstellung der für die elektronischen Bauteile benötigten Schichten mit Hilfe der Epitaxie entfallen diese Nachteile weitgehend. Der Herstellungsprozeß läßt sich in vielen Fällen sogar vereinfachen, die Stabilität und Qualität der Bauelement verbessern, die Ausbeute und Zuverlässigkeit erhöhen und damit lassen sich die Kosten beträchtlich senken.

Um die Vielfalt der möglichen Ausführungsformen zu beschränken, sind im folgenden alle SDD Typen so aufgebaut, daß sie auf der ersten Hauptoberfläche eine zusätzliche höher dotierte Epischicht E1 des gleichen Leitungstyps wie der Grundkörper aufweisen. Dies stellt keine Einschränkung dar, sondern eine besonders vorteilhafte erfindungsgemäße Ausführungsform von SDDs mit integrierter Elektronik.

Anhand verschiedener Ausführungsbeispiele, soll das erfindungsgemäße Verfahren der Herstellung von Strahlungsdetektoren, insbesondere von SDDs mit integrierter Elektronik unter Anwendung der Epitaxie erläutert werden. Dazu sind in den folgenden Figuren beispielhaft der Aufbau von JFETs, Bipolartransistoren und eines MOSFET gezeigt, die vorteilhafterweise im Anodenbereich von SDDs integriert werden können.

Bei den hier beschriebenen erfindungsgemäßen ersten Herstellungsverfahren werden die Epischichten nacheinander aufgebracht und strukturiert. Dies unterscheidet es von einem später erläuterten erfindungsgemäßen zweiten Herstellungsverfahren, bei dem zuerst mehrere bzw. alle Epischichten in einem Arbeitsschritt abgeschieden werden und die Strukturierung anschließend vorgenommen wird.

Natürlich ist auch die Kombination dieser beiden Verfahren mit der selektiven Epitaxie möglich und kann in speziellen Fällen besonders vorteilhaft sein.

Das erfindungsgemäße erste Verfahren wird nachstehend anhand von drei Ausführungsbeispielen unter Bezugnahme auf die Zeichnungen näher beschrieben, in der zeigen:

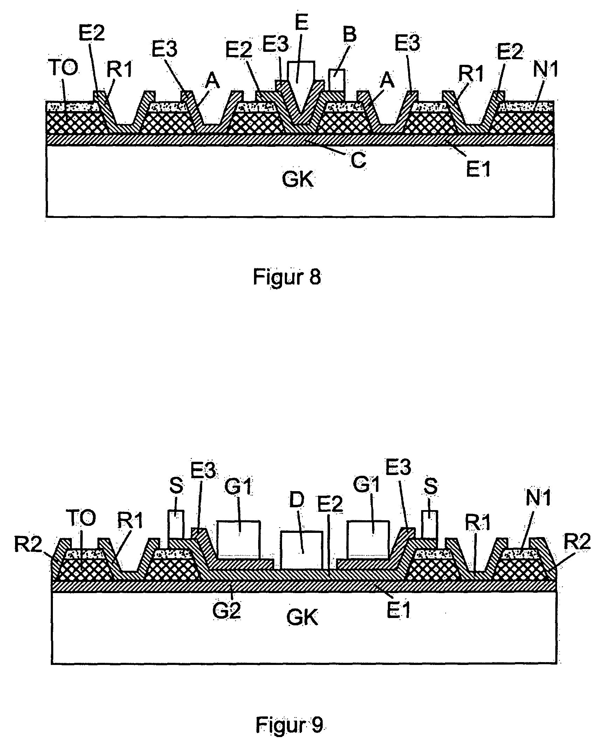

Fig. 8 einen nach dem erfindungsgemäßen Verfahren hergestellten npn-Bipolartransistor

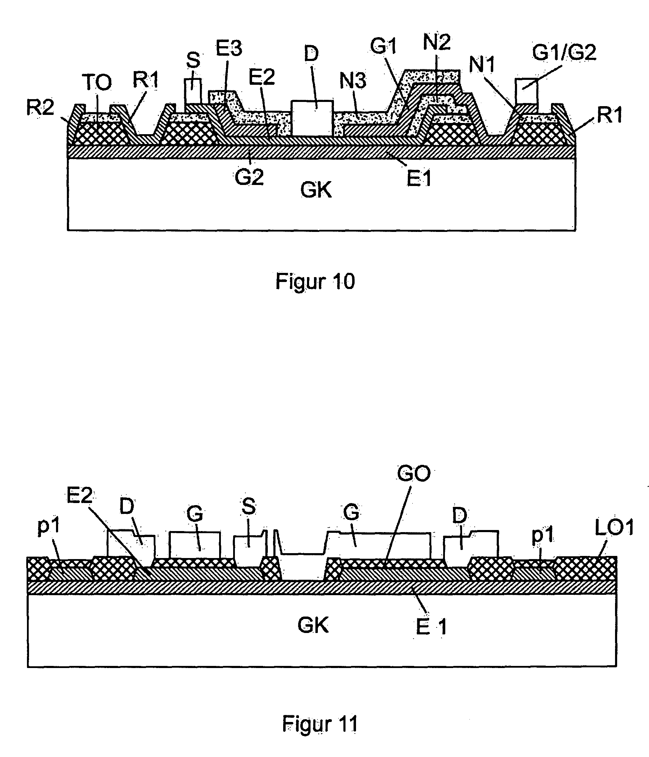

Fig. 9 einen nach dem erfindungsgemäßen Verfahren hergestellten JFET in ringförmiger Ausführung
Fig. 10 einen nach dem erfindungsgemäßen Verfahren hergestellten JFET in ringförmiger Ausführung mit verbundenen Gates G1 und G2

Fig. 8 zeigt den schematischen Querschnitt durch einen npn-Bipolartransistor, der als Resetelement in den Anodenbereich von SDDs integriert werden kann. Die durchgehende Epischicht E1 des ersten Leitungstyps auf der ersten Hauptoberfläche, die als Anode für die Majoritätsladungsträger dient, bildet gleichzeitig den Collector des Transistors. Darüber befinden sich mit Hilfe der Epitaxie hergestellte Schichten E2 und E3 für die Basis und den Emmitter.

Fig. 9 veranschaulicht den Aufbau eines zirkularen JFETs, der in den Anodenbereich von SDDs integriert werden kann. Dabei dient die Anode vom ersten Leitungstyp als inneres Gate G2 des Transistors, eine darauf abgeschiedene Epischicht E2 des zweiten Leitungstyps als Kanal und eine weitere darüber aufgebrachte Epischicht E2 des ersten Leitungstyps als äußeres Gate G1. Der Transistor wird durch die im inneren Gate G2 ankommende Ladung gesteuert.

Dieser JFET kann erfindungsgemäß auch als Resetelement benutzt werden. Die Schichtenfolge G1, S, G2 stellt nämlich einen parasitären npn-Bipolartransistor dar. Durch einen positiven Spannungspuls auf G1 läßt sich die Elektronenladung auf G2 neutralisieren bzw. absaugen.

Fig. 10 stellte eine Weiterbildung des JFET in Fig. 9 dar. In diesem Ausführungsbeispiel sind das innere und äußere Gate miteinander verbunden. Das Herstellungsverfahren verläuft nach dem gleichen Schema wie das des npn-Bipolartransistors der Fig. 8.

Bei der Herstellung der beschriebenen Ausführungsbeispiele von Detektoren und Transistoren wurde das erste Herstellungsverfahren mit sukzessiver Abscheidung und Strukturierung der einzelnen Epischichten angewandt. Aufgrund der technisch verfügbaren naßchemischen und trockenchemischen Strukturierungsverfahren sind eine ganze Vielfalt von Schrittfolgen realisierbar, die als Stand der Technik nicht im Detail erläutert werden brauchen. Diese können gegebenenfalls mit der Technik der selektiven Epitaxie kombiniert werden und damit besonders vorteilhaft sein.

Im folgenden wird deshalb der Schichtaufbau der Transistoren in Fig. 8 und Fig. 9 mit einem sehr einfachen technischen Verfahren beschrieben, bei dem Oxidschichten, Nitridschichten und Epitaxieschichten naßchemisch strukturiert werden. Dabei kommen als Ätzlösungen lediglich gepufferte Flußsäure und Phosphorsäure zum Einsatz.

Die Herstellung des npn-Bipolartransistors nach Fig. 8 verläuft nach folgender Sequenz:
Im ersten Schritt wird auf dem n-Typ Halbleitergrundkörper eine Epitaxieschicht E1 des gleichen Leitungstyps, jedoch mit höherer Dotierung abgeschieden.
Im zweiten Schritt wird die Siliciumscheibe thermisch oxidiert (TO).
Im dritten Schritt wird eine Siliciumnitridschicht N1 abgeschieden.
Im vierten Schritt wird die Siliciumnitridschicht strukturiert und in den Bereichen entfernt, wo später die p-Typ Epischichten abgeschieden werden sollen.
Im fünften Schritt wird das Oxid an den offenen Stellen weggeätzt.
Im sechsten Schritt wird das p-Typ Epi E2 abgeschieden.
Im siebten Schritt wird erneut Siliciumnitrid N2 abgeschieden.
Im achten Schritt wird das zweite Nitrid N2 strukturiert und überall dort geöffnet, wo die Epischicht E2 entfernt werden soll.
Im neunten Schritt wird die Epischicht E2 lokal abgeätzt.
Im zehnten Schritt werden die Anoden- A und Emmitterbereiche E in der Nitridschicht N2 geöffnet.
Im elften Schritt wird der Anodenbereich A im Oxid OT freigeätzt.
Im zwölften Schritt wird n-Typ Episilicium E3 abgeschieden.
Im dreizehnten Schritt wird eine dritte Nitridschicht N3 abgeschieden.
Im vierzehnten Schritt wird die Nitridschicht N3 strukturiert.
Im fünfzehnten Schritt wird die n-Typ Epischicht E3 strukturiert und der Anodenbereich A und der Emmitter E definiert
Im sechzehnten Schritt wird metallisiert.
Im siebzehnten Schritt die Metallschicht strukturiert.

Die Herstellung des JFET verläuft sinngemäß ähnlich. Obwohl das erfindungsgemäße erste Verfahren mit geringem technologischen Aufwand durchgeführt werden kann, weist es eine Reihe von Nachteilen auf. Dazu zählen die mehrmalige Abscheidung von Siliciumnitrid als Ätzmaske für die Epischichten, sowie die Kontaminationsgefahr während der Strukturierung der einzelnen Schichtenfolgen, sowie die jeweils erforderliche Reinigung vor den einzelnen Epitaxieprozessen. Weiterhin nachteilig ist die dabei entstehende dreidimensionale Topographie, die zu Abrissen an scharfen Kanten führen kann.

Einige dieser Nachteile des ersten Verfahrens lassen sich durch die Anwendung der selektiven Epitaxie, sowie trockener Ätzverfahren oder selektiver naßchemischer Prozesse vermeiden. Darauf soll jedoch nicht näher eingegangen werden, da sie als Stand der Technik betrachtet werden können, für den Experten naheliegend sind und den Erfindungsgedanken lediglich variieren.

Vorteilhafter ist jedoch ein erfindungsgemäßes zweites Verfahren. Bei diesem Verfahren werden alle oder mehrere Epischichten in einem Arbeitsprozess nacheinander abgeschieden, ohne daß die Siliciumscheiben den Epireaktor zwischendurch verlassen müssen.

Ein großer Vorteile des erfindungsgemäßen zweiten Verfahrens besteht nun darin, daß die Grenzflächen zwischen den einzelnen Epischichten keinerlei zusätzliche Kontaminationen oder Kristalldefekte aufweisen, da die Schichtenfolge ja in einem Arbeitsgang hergestellt wird. Die Veränderung des Leitungstyps läßt sich bekanntermaßen sehr einfach durch Umschalten auf die entsprechende Dotierquelle erreichen.

Die Aufgabe besteht nun darin, die einzelnen übereinander liegenden Schichten E1, E2, E3, E4 usw. gezielt zu isolieren, zu strukturieren und zu kontaktieren, so daß die gewünschten Detektorstrukturen und elektronischen Komponenten dabei entstehen.

Diese Aufgabe wird erfindungsgemäß durch die Anwendung an sich bekannter Verfahren der selektiven Epitaxie, der LOCOS Technik (lokale Oxidation), des Einsatzes naßchemischer und trockener isotroper und anisotroper sowie selektiver Ätztechniken, sowie der anodischen Oxidation bzw. des anodischen Ätzens gelöst.

Anhand einiger Ausführungsbeispiele werden diese Techniken bzw. Kombinationen davon im folgenden erläutert. Diese gelten wieder nur als beispielhaft und können in keiner Weise die vielfältigen Kombinationsmöglichkeiten erschöpfend beschreiben.

Das erfindungsgemäße Verfahren wird nachstehend anhand von Ausführungsbeispielen unter Bezugnahme auf die Zeichnungen näher beschrieben, in der zeigen:
Fig. 11 einen nach dem erfindungsgemäßen Verfahren hergestellten MOSFET auf zwei Epischichten E1 und E2

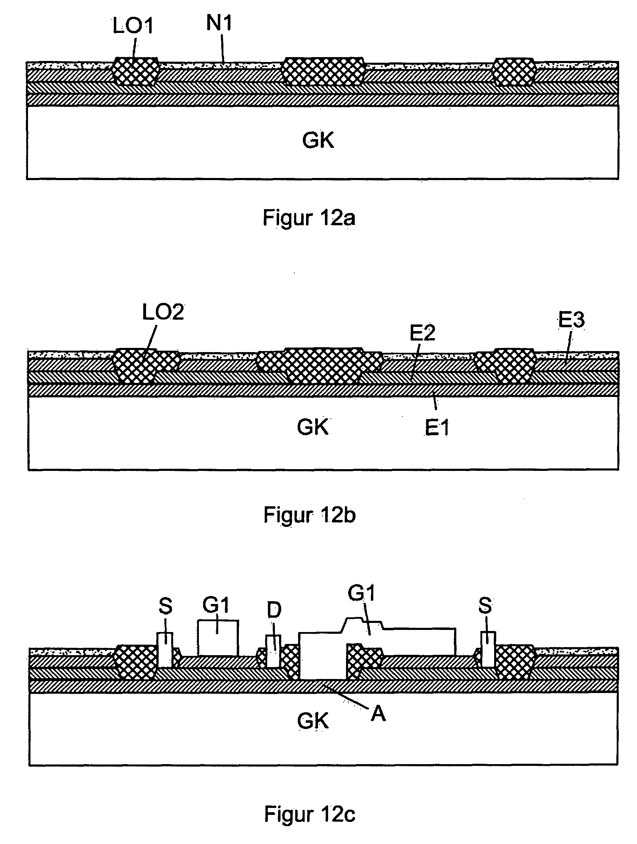

Fig. 12 einen nach dem erfindungsgemäßen Verfahren hergestellten zirkularen JFET mit verbundenen Gates auf drei Epischichten E1, E2 und E3

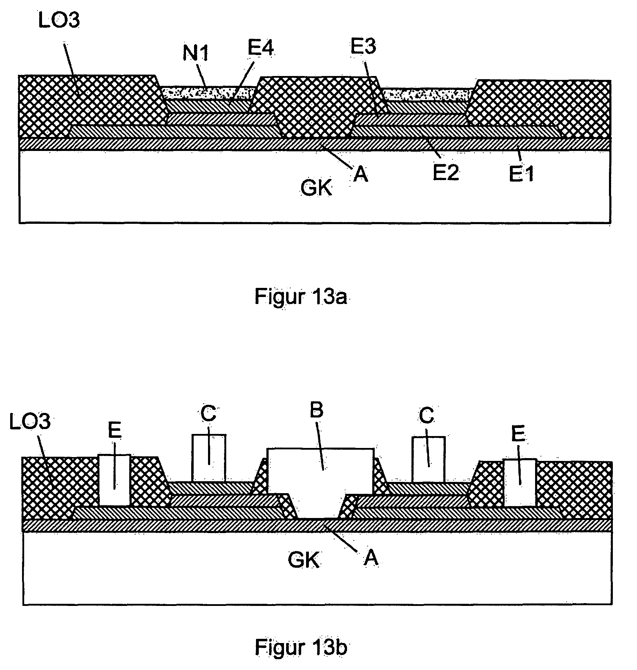

Fig. 13 einen nach dem erfindungsgemäßen Verfahren hergestellte pnp-Bipolartransistor auf vier Epischichten E1, E2, E3 und E4

Gleichzeitig mit diesen Bauelementen werden die gewünschten Strahlungsdetektoren, vorzugsweise SDDs hergestellt.

Fig. 11 stellt den Querschnitt durch einen schematisch dargestellten MOSFET dar, der sich durch Anwendung der LOCOS Technik auf eine Schichtenfolge von p-Typ Epi E2 auf n-Typ Epi E1 herstellen läßt. Durch lokale Oxidation LO der obersten Epischicht E2 läßt sich einerseits das Transistorgebiet von den Driftringen p1 isolieren ( die gleichzeitig hergestellt werden), anderseits ein isolierter Kontakt zur unteren n-Typ Epischicht E1 herstellen. Nach der Gateoxidation GO wird dieses strukturiert und die Kontaktlöcher zu Drain D, Source S und der Anode A geöffnet. Schließlich werden in einem Metallisierungsschritt die Kontaktierungen durchgeführt und dabei die Anode A mit dem Gate G verbunden.

Gleichzeitig mit der Herstellung des Transistors werden die Driftringe p1, p2, --- pn erzeugt und die erforderlichen Kontakte aufgebracht.

Fig. 12 zeigt die Herstellung eines erfindungsgemäßen JFETs unter Ausnutzung von drei Epischichten E1, E2 und E3 und unter zweimaliger Anwendung der LOCOS Technik. Dieser JFET eignet sich in hervorragender Weise als Verstärkungselement für SDDs, CCDs und Pixeldetektoren.

Die wichtigsten Schritte des Herstellungsverfahrens sollen nun anhand der Fig. 12a bis Fig. 12c erläutert werden. Fig. 12a zeigt die drei übereinanderliegenden Epischichten nach der ersten lokalen Oxidation LO1. Durch die aufgebrachte Siliciumnitridschicht N1 ist die Oxidation nur dort möglich, wo die Oberfläche nitridfrei ist. Diese Gebiete sollen später den Transistor gegen die Driftringe isolieren bzw. den Kontakt zur Anode ermöglichen.

Nach einer weiteren Strukturierung des Nitrids erfolgt nach Fig. 12b die zweite Oxidation LO2, die in ausgewählten Bereichen die Epischichten E2 und E1 aufzehrt. Wie aus Fig. 12c ersichtlich ist, können nun Kontaktlöcher zu den verschiedenen Gebieten geöffnet werden und schließlich Drain- D, Source- S und Gategebiete G mit Metallelektroden versehen werden. Bei diesem Ausführungsbeispiel ist die Anode A mit dem Gate G verbunden.

Fig. 13 zeigt in stark verkürzter Form die Herstellung eines pnp-Bipolartransistors auf einer Folge von vier Epischichten E1, E2, E3 und E4 unter dreimaliger Anwendung der LOCOS Technik. Dieser erfindungsgemäße Transistor kann in vorteilhafter Weise im Anodenbereich von SDDs integriert werden.

Fig. 13a zeigt den Zustand nach dreimaliger lokaler Oxidation LO3, in Anlehnung an den bereits am Beispiel des JFET der Fig. 12 erläuterten Verfahrens. Fig. 13b zeigt die Kontaktverbindungen nach Öffnen der Kontaktlöcher und Metallisierung. Bei diesem pnp-Bipolartransistor ist die Anode A mit der Basis B verbunden. Er ist demnach zur Signalverstärkung in SDDs, CCDs und Pixeldetektoren geeignet.

Zum besseren Verständnis wurde in den drei letzten Beispielen die LOCOS Technik zur Strukturierung und Isolation der Transistoren genutzt. Im Gegensatz zur klassischen LOCOS Technik, bei der eine thermische Oxidation durchgeführt wird, ist in diesen Fällen eine anodische Oxidation vorteilhafter, da diese bei Raumtemperatur durchgeführt werden kann. Bei Anwendung der thermischen Oxidation besteht die Gefahr, daß die abrupten Dotierungsprofile der einzelnen Epischichten durch Diffusion verschmiert werden. Dies kann gegebenenfalls durch feuchte Oxidation bei niedrigen Temperaturen oder durch Hochdruckoxidation in erträglichen Grenzen gehalten werden, stellt jedoch einen Nachteil hinsichtlich der Qualität der Bauelemente dar.

Das erfindungsgemäße Verfahren läßt sich daher in der Kombination der LOCOS Technik mit selektiven, isotropen und anisotropen trockenen und naßchemischen Ätzungen den technologischen Gegebenheiten anpassen. So kann man bekanntermaßen n-Typ Silicium selektiv über hochdotiertem p-Typ Silicium gezielt mit KOH abätzen, da der Ätzvorgang von selbst nach Erreichen des p-Typ Siliciums stoppt. Auch das elektrochemische Ätzen eignet sich hervorragend dafür, Schichten eines bestimmten Leitungstyps gezielt zu entfernen. Durch Verwenden von geeigneten Elektrolyten kann elektochemisch sowohl oxidiert als auch geätzt werden.

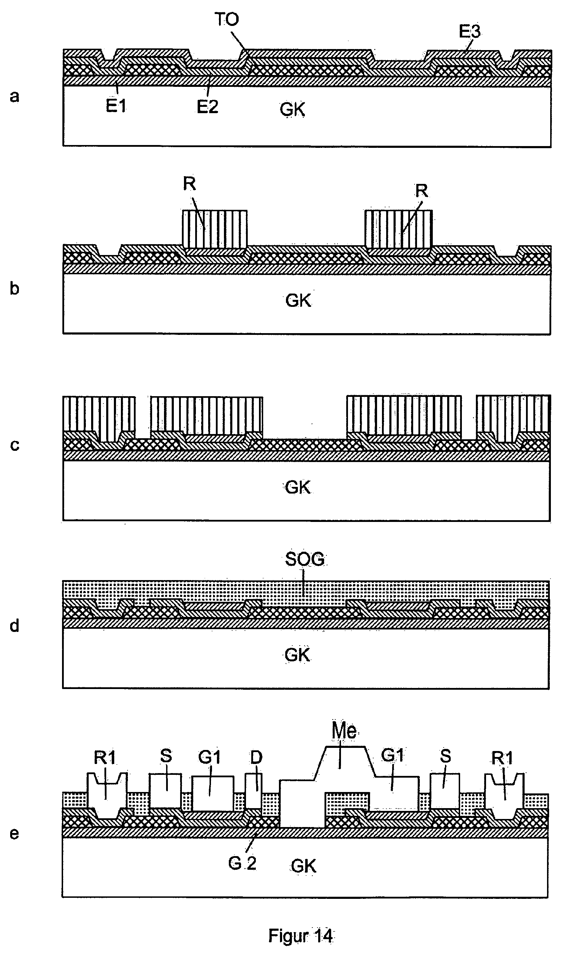

Hinsichtlich der Qualität der Bauelemente sind alle Verfahren, die hohe Temperaturen vermeiden, den Hochtemperaturverfahren überlegen und deshalb vorteilhafterweise zu benutzen. Ein letztes Ausführungsbeispiel, das thermische Oxidation, selektives Ätzen mit KOH, sowie elektrochemisches Ätzen in vorteilhafter Weise kombiniert, ist in Fig.14 beschrieben.

Fig. 14 zeigt einen nach dem erfindungsgemäßen Verfahren hergestellten Driftdetektor und zirkularen JFET mit verbundenen Gates G1 und G2 unter Angabe der wichtigsten Verfahrensschritte für den JFET.

In Fig. 14 sind von a bis e die wichtigsten Schritte eines besonders schonenden, kombinierten Verfahrens zur Herstellung von SDDs, mit einem integrierten zirkularen JFET dargestellt. Ausgangsbasis ist in diesem Fall eine bereits mit einer niederohmigeren n-Typ Epischicht E1 versehene n-Typ Siliciumscheibe .

Die Scheibe wird thermisch oxidiert (TO) und auf der zweiten Hauptoberfläche mit einer geeigneten Schutzschicht passiviert (z.B. Photoresist). Die erste Hauptoberfläche, auf der die Driftstrukturen und der integrierte Transistor hergestellt werden sollen, wird zunächst photolithographisch strukturiert und das Oxid TO überall dort weggeätzt, wo Kontakte zur n-Typ Epischicht E1 des Grundkörpers hergestellt werden sollen. Dies sind die Driftringe R1, R2, ---Rn, ein Kontakt (nicht sichtbar) zum Absaugen der Elektronen unter dem Oxid im Driftbereich, die Guardringstruktur (nicht gezeitgt) sowie die späteren Kanalbereiche des JFETs.

Im nächsten Schritt wird in einem einzigen Prozeß p-Typ Episilicium E2 und n-Typ Episilicium E3 abgeschieden, wie in Fig. 14a dargestellt. Durch selektives Ätzen mit KOH wird nun die n-Typ Epischicht E3 überall entfernt, außer im Gatebereich G des JFET bzw. im Randbereich des Detektors, um dort ebenfalls elektronische Bauteile zu integrieren. Hierauf wird die Scheibe mit Photolack R (Resist) beschichtet und die Bereiche freigelegt, in denen die p-Typ Epischicht E2 entfernt werden soll. Dieser Zustand ist in Fig. 14b dargestellt und definiert die Drift- und Guardringe (nicht dargestellt) und insbesondere auch die Transistorbereiche und die späteren Verbindungen zur n-Typ Epischicht E1 des Grundkörpers.

Als nächstes wird nun elektrochemisch das p-Typ Episilicium E2 an allen offenen Stellen entfernt und dabei Driftringe und Guardringe strukturiert. Im Zentrum des Transistors wird das p-Typ Episilicium E2 ebenfalls weggeätzt, wie in Fig. 14c ersichtlich ist. Danach wird eine Passivierung z.B. mit SOG (Spin on glass) oder einem CVD Oxid vorgenommen, wie in Fig. 14 d veranschaulicht ist.

Im nächsten Schritt wird die zweite Hauptoberfläche bearbeitet (nicht dargestellt), auf der als erstes das Gebiet für das großflächige Strahleintrittsfenster und eventuelle Guardringe freigelegt werden. Hierauf wird die p-Typ Epischicht abgeschieden und wie oben geschildert strukturiert. Danach folgt die Metallisierung, vorzugsweise mit TiN und Aluminium. Schließlich werden die Strukturen durch eine Schutzschicht aus Photoresist ganzflächig abgedeckt.

Nun wird auf der ersten Hauptoberfläche die Schutzschicht SOG plus TO überall dort durchgeätzt, wo Kontakte zur n-Typ Epischicht E1 des Grundkörpers hergestellt werden sollen. Im Transistorbereich ist dies ein Kontaktloch im Zentrum , das einmal die Verbindung des inneren Gates G2 zum äußeren Gate G1 herstellen soll. Danach werden die Kontaktlöcher auf der ersten Hauptoberfläche freigeätzt und die Metallisierung, vorzugsweise mit TiN und Aluminium vorgenommen, wie in Fig. 14 d veranschaulicht ist. Als letztes wird der Photoresist auf beiden Hauptoberlächen entfernt.

Das fertige Bauelement stellt einen SDD mit einem zirkularen JFET dar, der im Zentrum eine metallische Verbindung des inneren Gate G2 mit dem äußeren Gate G1 aufweist. Da bei diesem erfindungsgemäßen Verfahren nach der Epiabscheidung keine Hochtemperaturschritte mehr erforderlich sind, ist es besonders schonend und für die Herstellung rauscharmer Detektoren geeignet.

Die hier beschriebenen Verfahren und Bauelemente wurden nur beispielhaft ausgewählt, um den Erfindungsgedanken zu erläutern und stellen keine Einschränkung desselben dar. So können gleichzeitig mit den Detektoren und Transistoren auch andere elektronische Schaltungselemente, wie Kapazitäten, Widerstände oder Dioden mit Hilfe einer oder mehrere Epischichten und sonstiger leitfähiger Schichtenhergestellt werden. Für ihre Integration eignen sich vorzugsweise die Randgebiet der Detektoren.

Insbesondere ist es sinngemäß möglich einen Halbleitergrundkörper mit p-Typ Leitfähigkeit zu verwenden und die Dotierungen der Epischichten sinngemäß zu verändern. Auch kann es von besonderem Vorteil sein, innerhalb der Epischichten das Dotierungsprofil zu variieren, um spezielle Eigenschaften der Bauelemente zu optimieren. Weiterhin kann es vorteilhaft sein, einen kommerziell erhältlichen Grundkörper aus Silicium auszuwählen, der bereits schon einen komplexen Schichtaufbau aufweist. Dies können Epischichten oder auch eine Kombination von Epischichten und Isolationsschichten sein. Auch durch geeignete Wahl der Kristallorientierung des Grundkörpers kann die Technologie speziellen Bedürfnissen angepaßt werden. Dies gilt insbesondere für die Anwendung anisotroper Ätzverfahren.

Bei der Wahl der Ausführungsbeispiele wurden insbesondere beim zweiten Verfahren Transistoren bevorzugt, die sich auf der ersten Hauptoberfläche eines SDD befinden. Natürlich können beide Hauptoberflächen eines Detektors nach diesen Verfahren gleichzeitig oder nacheinander strukturiert werden. In manchen Fällen mag eine Kombination des ersten mit dem zweiten Verfahren besonders vorteilhaft sein. Auch stellt die Anwendung auf SDDs keine Eischränkung dar, sondern wurde nur als Beispiel gewählt. Das Verfahren eignet sich auch in hervorragender Weise, CCDs insbesondere pn-CCDs und Pixeldetektoren mit integrierten elektronischen Komponenten herzustellen, da die Herstellungsschritte für diese Bauelementen weitgehend identisch mit denen von SDDs sind.

Ebenso stellt die Wahl von Silicium als Detektormaterial keine Einschränkung des Erfindungsgedankens dar. Sinngemäß läßt sich das Verfahren auch auf andere Halbleiter wie Germanium, Cadmiumtellurid oder Galliumarsenid usw. übertragen. Dabei sind bei der Strukturierung die für diese Materialien geeigneten Verfahren anzuwenden. Auch ist es möglich Epischichten eines anderen Halbleitermaterials als des Grundkörpers abzuscheiden, um die Vorteile verschiedener Materialien miteineander zu kombinieren. So können beispielsweise die elektronischen Komponenten in der beschriebenen Weise aus Episilicium aufgebaut werden, das auf einem für die Absorption von Strahlung besser geeigneten Grundkörper aufgebracht wird.

Obwohl das erfindugnsgemäße Verfahren die Ionenimplantation als Dotierungsverfahren für die Herstellung der Gebiete des ersten und zweiten Leitungstyps vermeidet, kann es vorteilhaft sein, diese lokal anzuwenden, um die Eigenschaften der Detektoren und der elektronischen Komponenten gezielt zu beeinflussen. So läßt sich z.B. durch eine zusätzliche Implantationsdotierung im Randbereich die Durchbruchspannung von Sperrschichten erhöhen, die nach dem erfindungsgemäßen Verfahren hergestellt werden. Weiterhin kann es vorteilhaft sein, die Implantation zur Erzeugung der Driftstrukturen anzuwenden während das Eintrittsfenster durch Epitaxie hergestellt wird.

## Patentansprüche

**1.** Verfahren zur Herstellung von Halbleiter-Strahlungsdetektoren mit einem Grundkörper eines ersten Leitungstyps zum Nachweis der Strahlung und darauf befindlichen strukturierten weiteren Halbleiterschichten eines zweiten und/oder des ersten Leitungstyps,
**dadurch gekennzeichnet, dass** wenigstens eine der weiteren Halbleiterschichten durch Epitaxie aufgebracht wird.

**2.** Verfahren nach Anspruch 1,
**dadurch gekennzeichnet, dass** wenigstens eine der weiteren Halbleiterschichten auf wenigstens einer Hauptoberfläche oder alle Halbleiterschichten auf den beiden Hauptoberflächen durch Epitaxie aufgebracht werden.

**3.** Verfahren nach Anspruch 1 oder 2,
**dadurch gekennzeichnet, dass** jeweils eine Epischicht abgeschieden und strukturiert wird.

**4.** Verfahren nach Anspruch 1 oder 2,
**dadurch gekennzeichnet, dass** mehrere Epischichten unterschiedlichen Leitungstyps und/oder untersciedlicher Dotierung in einem einzigen Abscheidevorgang hintereinander abgeschieden und dann strukturiert werden.

**5.** Verfahren nach einem der Ansprüche 1 bis 4,
**dadurch gekennzeichnet, dass** Epischichten des ersten und zweiten Leitungstyps und unterschiedlicher Dotierung wahlweise übereinander abgeschieden werden.

**6.** Verfahren nach einem der Ansprüche 1 bis 5,
**dadurch gekennzeichnet, dass** Epischichten auch zur Kontaktierung von Strahlungsdetektoren, von oder als elektronische Bauteile und insbesondere als aktive und/oder passive elektronische Komponenten und/oder als Leiterbahnen benutzt werden.

**7.** Verfahren nach Anspruch 6,
**dadurch gekennzeichnet, dass** die aktiven Bauelemente vorzugsweise Dioden, MOSFETs, JFETs und Bipolartransistoren und die passiven Komponenten vorzugsweise Widerstände und Kapazitäten sind.

**8.** Verfahren nach einem der Ansprüche 1 bis 7,
**dadurch gekennzeichnet, dass** eine dünne Epischicht als Strahleintrittsfenster verwendet wird.

**9.** Verfahren nach einem der Ansprüche 1 bis 8,
**dadurch gekennzeichnet, dass** pn-Detektoren, Streifendetektoren, Halbleiter-Strahlungsdetektoren, Pixel-Detektoren und CCDs hergestellt werden.

**10.** Verfahren nach einem der Ansprüche 1 bis 9,
**dadurch gekennzeichnet, dass** elektronische Komponenten monolithisch auf den Detektoren integriert werden und diese gleichzeitig mit den Detektoren hergestellt werden.

**11.** Verfahren nach einem der Ansprüche 1 bis 9,
**dadurch gekennzeichnet, dass** elektronische Komponenten und Detektoren in getrennten Arbeitsschritten hergestellt werden.

**12.** Verfahren nach einem der Ansprüche 1 bis 11,
**dadurch gekennzeichnet, dass** zur Strukturierung der Epischichten die selektive Epitaxie, isotrope, anisotrope sowie selektive elektrochemische, naßchemische und trockene Ätzverfahren eingesetzt werden.

**13.** Verfahren nach einem der Ansprüche 1 bis 14, **dadurch gekennzeichnet, dass** für die Isolation verschiedener Bereiche vorzugsweise thermische Oxidation, LOCOS Technik, CVD-Prozesse, anodische Oxidation, sowie SOG oder PSG eingesetzt werden.

**14.** Verfahren nach einem der Ansprüche 1 bis 13,
**dadurch gekennzeichnet, dass** für die Herstellung von Guardstrukturen vorzugsweise die gleichen Epischichten wie zur Herstellung der Driftregionen auf der ersten Hauptoberfläche bzw. der Strahleintrittsfenster auf der zweiten Hauptoberfläche benutzt werden.

**15.** Verfahren nach einem der Ansprüche 1 bis 14,
**dadurch gekennzeichnet, dass** zur Integration von Transistoren, vorzugsweise JFETs und Bipolartransistoren in Halbleiter- Strahlungsdetektoren eine oder mehrere Epischichten des zweiten und ersten Leitungstyps auf der ersten Hauptoberfläche eines Grundkörpers des ersten Leitungstyps - vorzugsweise mit einer höher dotierten Epischicht des ersten Leitungstyps im Bereich der ersten Hauptoberfläche und mit einer strukturierten Isolationsschicht versehen - nacheinander aufgebracht, strukturiert, isoliert und kontaktiert werden.

**16.** Verfahren nach einem der vorhergehenden Ansprüche,
**dadurch gekennzeichnet, dass** zur Integration von Transistoren, vorzugsweise JFETs und Bipolartransistoren in Halbleiter- Strahlungsdetektoren eine oder mehrere Epischichten des zweiten und ersten Leitungstyps auf der ersten Hauptoberfläche eines Grundkörpers des ersten Leitungstyps - vorzugsweise mit einer höher dotierten Epischicht des ersten Leitungstyps im Bereich der ersten Hauptoberfläche - in einem Arbeitsschritt nacheinander aufgebracht werden und danach strukturiert, isoliert und kontaktiert werden.

**17.** Verfahren nach Anspruch 15 oder 16,
**dadurch gekennzeichnet, dass** zur Herstellung von MOSFETs in Strahlungsdetektoren ein zusätzliches Gateoxid hergestellt wird.

**18.** Verfahren nach einem der Ansprüche 1 bis 17,
**dadurch gekennzeichnet, dass** eine oder mehrere Epischichten für die Herstellung der elektronischen Komponenten auch für die Herstellung von Detektorgebieten und Guardstrukturen benutzt werden.

**19.** Halbleiter-Strahlungsdetektor mit einem Grundkörper eines ersten Leitungstyps zum Nachweis der Strahlung und darauf befindlichen strukturierten weiteren Halbleiterschichten eines zweiten und/oder des ersten Leitungstyps,
**dadurch gekennzeichnet, dass** wenigstens eine der weiteren Halbleiterschichten durch Epitaxie aufgebracht ist.

**20.** Halbleiter-Strahlungsdetektor nach Anspruch 19,
**dadurch gekennzeichnet, dass** der Grundkörper des ersten Leitungstyps vorzugsweise aus Silicium der Orientierung (100) besteht und eine n-Typ Dotierung aufweist und dass auf der ersten Hauptoberfläche eine Epischicht aus p-Typ Silicium aufgebracht ist und auf der zweiten Hauptoberfläche eine Epischicht aus n-Typ Silicium.

**21.** Halbleiter-Strahlungsdetektor nach Anspruch 19 oder 20,
**dadurch gekennzeichnet, dass** der Grundkörper des ersten Leitungstyps auf mindestens einer Hauptoberfläche, vorzugsweise auf der ersten Hauptoberfläche eine höher dotierte Epischicht des ersten Leitungstyps aufweist.

**22.** Halbleiter-Strahlungsdetektor nach einem der Ansprüche 19-21,
**dadurch gekennzeichnet, dass** auf der ersten Hauptoberfläche Driftstrukturen und Strukturen zum Spannungsabbau aus wenigstens einer Epischicht des zweiten Leitungstyps vorhanden sind und
dass er als Strahleintrittsfenster und zum Spannungsabbau auf der zweiten Hauptoberfläche wenigstens eine Epischicht des zweiten Leitungstyps aufweist.

**23.** Halbleiter-Strahlungsdetektor nach Anspruch 20, **dadurch gekennzeichnet, dass** er im Anodenbereich eine Epischicht des ersten Leitungstyps aufweist.

**24.** Halbleiter-Strahlungsdetektor nach Anspruch 21 oder 22,
**dadurch gekennzeichnet, dass** er im Anodenbereich eine Metallisierung des Grundkörpers bzw. der darauf abgeschiedenen Epischicht des ersten Leitungstyps aufweist, vorzugsweise aus TiN und Aluminium.

**25.** Halbleiter-Strahlungsdetektor nach einem der Ansprüche 19 bis 24,
**dadurch gekennzeichnet, dass** er im Bereich des Driftgebietes und im Randbereich eine Widerstandsschicht aus einer Epischicht des zweiten Leitungstyps aufweist.

**26.** Halbleiter-Strahlungsdetektor nach einem der Ansprüche 19 bis 25,
**dadurch gekennzeichnet, dass** er auf der zweiten Hauptoberfläche, im Bereich des Strahleintrittsfensters und im Randbereich eine Widerstandsschicht aus einer Epischicht des zweiten Leitungstyps aufweist.

**27.** Halbleiter-Strahlungsdetektor nach einem der Ansprüche 19 bis 26,
**dadurch gekennzeichnet, dass** sich die Anode im Zentrum des Driftbereiches befindet.

**28.** Halbleiter-Strahlungsdetektor nach einem der Ansprüche 19 bis 26,
**dadurch gekennzeichnet, dass** sich die Anode am Rande des Driftbereiches befindet.

**29.** Halbleiter-Strahlungsdetektor nach einem der Ansprüche 19 bis 26,
**dadurch gekennzeichnet, dass** sich die Anode am Rande des Driftbereiches befindet und diesen vorzugsweise in Form eines geschlossenen oder unterbrochenen Ringes umschließt.

**30.** Halbleiter-Strahlungsdetektor, zusammengesetzt aus mehreren Zellen, nach Anspruch 29,
**dadurch gekennzeichnet, dass** mehrere Zellen eine gemeinsame Anode besitzen.

**31.** Halbleiter-Strahlungsdetektor nach einem der Ansprüche 19 bis 30,
**dadurch gekennzeichnet, dass** er zur Bildung von Driftstrukturen aus mindestens einer Epischicht des zweiten Leitungstyps aufgebaut ist, und
dass er aus in sich geschlossenen Ringen, Spiralen, spiralartig verbundenen Ringen oder geschlossenen Flächen besteht, die direkten Kontakt zum Grundkörper haben.

**32.** Halbleiter-Strahlungsdetektor nach einem der Ansprüche 19 bis 31,
**dadurch gekennzeichnet, dass** er zur Bildung von Guardstrukturen zum Abbau hoher elektrischer Spannungen aus mindestens einer Epischicht des zweiten Leitungstyps aufgebaut ist, und
dass er aus in sich geschlossenen Ringen, Spiralen oder spiralartig verbundenen Ringen besteht, die direkten Kontakt zum Halbleitergrundkörper haben.

**33.** Halbleiter-Strahlungsdetektor nach einem der Ansprüche 19 bis 32,
**dadurch gekennzeichnet, dass** er zur Bildung von Guardstrukturen zum Abbau hoher elektrischer Spannungen aus Episilicium des ersten oder zweiten Leitungstyps aufgebaut ist, und
dass er aus flächenartigen Gebieten, Spiralen oder spiralartig verbundenen Ringen besteht, die auf einer Isolationsschicht aufgebracht sind und im Innern mit dem Gebiet hoher Spannung und am Rand mit dem Halbleitergrundkörper verbunden sind.

**34.** Halbleiter-Strahlungsdetektor nach einem der Ansprüche 19 bis 33,
**dadurch gekennzeichnet, dass** zur Bildung eines pn-CCDs mit einem Grundkörper des ersten Leitungstyps auf der ersten Hauptoberfläche Gebiete aus mindestens einer Epischicht des ersten und zweiten Leitungstyps vorhanden sind, und
dass als Strahleintrittsfenster und zum Spannungsabbau auf der zweiten Hauptoberfläche mindestens eine Epischicht des zweiten Leitungstyps abgeschieden ist.

**35.** Halbleiter-Strahlungsdetektor nach einem der Ansprüche 19 bis 34,
**dadurch gekennzeichnet, dass** zur Bildung eines Pixeldetektors mit einem Grundkörper des ersten Leitungstyps auf der ersten Hauptoberfläche Gebiete aus Epischichten des ersten und zweiten Leitungstyps vorhanden sind, und
dass als Strahleintrittsfenster und zum Spannungsabbau auf der zweiten Hauptoberfläche mindestens eine Epischicht des zweiten Leitungstyps abgeschieden ist.

**36.** Halbleiter-Strahlungsdetektor nach einem der Ansprüche 19 bis 36,
**dadurch gekennzeichnet, dass** er zur Bildung von Strukturen zum Absaugen von Elektronen unter dem Oxid aus Epischichten des ersten oder zweiten Leitungstyps aufgebaut ist, und
dass er Spiralen, oder spiralartig verbundenen Ringe auf dem Oxid aufweist.

**37.** Halbleiter-Strahlungsdetektor nach einem der Ansprüche 19 bis 36,
**dadurch gekennzeichnet, dass** der Grundkörper vorzugsweise aus Si, Ge, Diamant, GaAs, AlGaAs, CdTe oder anderen heterogenen Halbleitern besteht und daß als Epischichten Halbleiterschichten des Grundkörpers oder eines anderen Halbleiters verwendet werden.

**38.** Halbleiter-Strahlungsdetektor nach einem der Ansprüche 19 bis 37,
**dadurch gekennzeichnet, dass** er im Randbereich des Eintrittsfensters eine zusätzliche Dotierung durch Ionenimplantation aufweist.

**38.** Halbleiter-Strahlungsdetektor nach einem der Ansprüche 19 bis 37,
**dadurch gekennzeichnet, dass** die Driftstrukturen durch Ionenimplantation und das Eintrittsfenster durch Epitaxie hergestellt ist.

**39.** Eintrittsfenster für einen Halbleiter-Strahlungsdetektore nach einem der einem der Ansprüche 19 bis 38,
**dadurch gekennzeichnet, dass** sich auf mindestens einer Hauptoberfläche eines Halbleitergrundkörper eine dünne Epischicht befindet.

**40.** Eintrittsfenster nach Anspruch 39,
**dadurch gekennzeichnet, daß** die Epischicht vom gleichen oder entgegengesetzten Leitungstyp wie der Grundkörper ist.

**41.** Eintrittsfenster nach Anspruch 39 oder 40,
**dadurch gekennzeichnet, daß** die Epischicht unterschiedliche Dotierungen aufweist.

**42.** Eintrittsfenster nach einem der Ansprüche 39 bis 41,
**dadurch gekennzeichnet, daß** sich auf der Epischicht eine dünne Schicht eines Dielektrikums, vorzugsweise thermisches Siliciumoxid, befindet.
